(19) Europäisches Patentamt
European Patent Office
Office européen des brevets

(11) **EP 4 622 098 A1**

(12) **EUROPEAN PATENT APPLICATION**
published in accordance with Art. 153(4) EPC

(43) Date of publication:
**24.09.2025 Bulletin 2025/39**

(21) Application number: **23918735.4**

(22) Date of filing: **27.09.2023**

(51) International Patent Classification (IPC):
**H03F 1/26** (2006.01)    **H03F 1/56** (2006.01)
**H03F 3/193** (2006.01)    **H03F 1/22** (2006.01)

(52) Cooperative Patent Classification (CPC):
**H03F 1/22; H03F 1/26; H03F 1/56; H03F 3/193**

(86) International application number:
**PCT/KR2023/015074**

(87) International publication number:
**WO 2024/158100 (02.08.2024 Gazette 2024/31)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **25.01.2023 KR 20230009643**

(71) Applicant: **Samsung Electronics Co., Ltd.
Suwon-si, Gyeonggi-do 16677 (KR)**

(72) Inventors:
• **KIM, Kihyun
Suwon-si Gyeonggi-do 16677 (KR)**
• **KIM, Jinhyun
Suwon-si Gyeonggi-do 16677 (KR)**

(74) Representative: **Gulde & Partner
Patent- und Rechtsanwaltskanzlei mbB
Berliner Freiheit 2
10785 Berlin (DE)**

(54) **LOW NOISE AMPLIFIER FOR LOW LOSS, AND DEVICE COMPRISING SAME**

(57)    The disclosure relates to a 5G or 6G communication system for supporting a higher data transmission rate. According to various embodiments of the present disclosure, a low noise amplifier may comprise a first inductor, a second inductor and a capacitor, wherein the first inductor and the second inductor are arranged in parallel to each other, the first inductor and the second inductor are in a resonance state, and the capacitor can be arranged between the first inductor and the second inductor so as to be spaced apart therefrom.

FIG.3

Processed by Luminess, 75001 PARIS (FR)

**Description**

[Technical Field]

The disclosure relates to a wireless communication system, and more particularly, to a low noise amplifier for low loss in a wireless communication system and a device including the low noise amplifier.

[Background Art]

5G mobile communication technologies define broad frequency bands to enable high transmission rates and new services, and can be implemented not only in "Sub 6GHz" bands such as 3.5GHz, but also in ultrahigh frequency ("Above 6GHz") bands referred to as mmWave such as 28GHz and 39GHz. In addition, it has been considered to implement 6G mobile communication technologies (referred to as Beyond 5G systems) in terahertz bands (e.g., 95GHz to 3THz bands) in order to accomplish transmission rates fifty times faster than 5G mobile communication technologies and ultra-low latencies one-tenth of 5G mobile communication technologies.

At the beginning of 5G mobile communication technologies, in order to support services and to satisfy performance requirements in connection with enhanced Mobile BroadBand (eMBB), Ultra Reliable & Low Latency Communications (URLLC), and massive Machine-Type Communications (mMTC), there has been ongoing standardization regarding beamforming and massive MIMO for alleviating radio-wave path loss and increasing radio-wave transmission distances in mmWave, numerology (for example, operating multiple subcarrier spacings) for efficiently utilizing mmWave resources and dynamic operation of slot formats, initial access technologies for supporting multi-beam transmission and broadbands, definition and operation of BWP (BandWidth Part), new channel coding methods such as a LDPC (Low Density Parity Check) code for large-capacity data transmission and a polar code for highly reliable transmission of control information, L2 pre-processing, and network slicing for providing a dedicated network customized to a specific service.

Currently, there are ongoing discussions regarding improvement and performance enhancement of initial 5G mobile communication technologies in view of services to be supported by 5G mobile communication technologies, and there has been physical layer standardization regarding technologies such as Vehicle-to-everything (V2X) for aiding driving determination by autonomous vehicles based on information regarding positions and states of vehicles transmitted by the vehicles and for enhancing user convenience, New Radio Unlicensed (NR-U) aimed at system operations conforming to various regulation-related requirements in unlicensed bands, NR UE Power Saving, Non-Terrestrial Network (NTN) which is UE-satellite direct communication for securing coverage in an area in which communication with terrestrial networks is unavailable, and positioning.

Moreover, there has been ongoing standardization in wireless interface architecture/protocol fields regarding technologies such as Industrial Internet of Things (IIoT) for supporting new services through interworking and convergence with other industries, IAB (Integrated Access and Backhaul) for providing a node for network service area expansion by supporting a wireless backhaul link and an access link in an integrated manner, mobility enhancement including conditional handover and DAPS (Dual Active Protocol Stack) handover, and two-step random access for simplifying random access procedures (2-step RACH for NR). There also has been ongoing standardization in system architecture/service fields regarding a 5G baseline architecture (for example, service based architecture or service based interface) for combining Network Functions Virtualization (NFV) and Software-Defined Networking (SDN) technologies, and Mobile Edge Computing (MEC) for receiving services based on UE positions.

If such 5G mobile communication systems are commercialized, connected devices that have been exponentially increasing will be connected to communication networks, and it is accordingly expected that enhanced functions and performances of 5G mobile communication systems and integrated operations of connected devices will be necessary. To this end, new research is scheduled in connection with eXtended Reality (XR) for efficiently supporting Augmented Reality (AR), Virtual Reality (VR), Mixed Reality (MR), etc., 5G performance improvement and complexity reduction by utilizing Artificial Intelligence (AI) and Machine Learning (ML), AI service support, metaverse service support, and drone communication.

Furthermore, such development of 5G mobile communication systems will serve as a basis for developing not only new waveforms for securing coverage in terahertz bands of 6G mobile communication technologies, Full Dimensional MIMO (FD-MIMO), multi-antenna transmission technologies such as array antennas and large-scale antennas, metamaterial-based lenses and antennas for improving coverage of terahertz band signals, high-dimensional space multiplexing technology using Orbital Angular Momentum (OAM), and Reconfigurable Intelligent Surface (RIS), but also full-duplex technology for increasing frequency efficiency of 6G mobile communication technologies and improving system networks, AI-based communication technology for implementing system optimization by utilizing satellites and AI (Artificial Intelligence) from the design stage and internalizing end-to-end AI support functions, and next-generation distributed computing technology for implementing services at levels of complexity exceeding the limit of UE operation capability by utilizing ultra-high-performance communication and computing resources.

An electronic device that transmits or receives a millimeter wave (mmWave) band signal in a wireless communication system may include a radio frequency integrated chip (RFIC) for radio frequency (RF) signal processing. In this instance, an RFIC may include an amplifier (e.g., cascode amplifier or differential amplifier) including a power amplifier (PA) and a low noise amplifier (LNA). To minimize loss, a switch (e.g., antenna switch) that controls a power amplifier and a low noise amplifier may be required when designing an RFIC. In this instance, in the case of an antenna switch that controls both a power amplifier and a low noise amplifier, a capacitor may need to be additionally disposed in the antenna switch for impedance matching and loss may occur due to the added capacitor. That is, an element added for impedance matching may cause loss and efficiency may be low. Therefore, in order to minimize loss associated with matching by the antenna switch, a structure of an RFIC and a low noise amplifier, which provides high efficiency although an element for a separate switch is not added between a power amplifier and the low noise amplifier, may be required.

[Disclosure of Invention]

[Technical Problem]

Based on the discussion as described above, the disclosure is to provide an apparatus and a method capable of seamless efficiency of services in a wireless communication system.

According to various embodiments of the disclosure, the disclosure provides a structure that minimizes matching loss by using a structure of a low noise amplifier including parallel resonant inductors in a wireless communication system.

In addition, the disclosure improves the performance of a radio frequency integrated circuit (RFIC) via a structure in which a power amplifier is connected with a switch in series and a low noise amplifier includes parallel resonant inductors, in a wireless communication system.

[Solution to Problem]

According to various embodiments of the disclosure, a low noise amplifier may include a first inductor, a second inductor, and a capacitor, and the first inductor and the second inductor may be disposed in parallel, the first inductor and the second inductor may be in a resonant state (resonance), and the capacitor may be disposed between the first inductor and the second inductor with a space therefrom.

According to various embodiments of the disclosure, an electronic device of a wireless communication system may include a plurality of radio frequency integrated circuits (RFICs), and at least one RFIC of the plurality of RFICs may include a low noise amplifier, the low noise amplifier may include a first inductor, a second inductor, and a capacitor, the first inductor and the second inductor may be disposed in parallel, the first inductor and the second inductor may be in a resonant state (resonance), and the capacitor may be disposed between the first inductor and the second inductor with a space therefrom.

[Advantageous Effects of Invention]

Various embodiments of the disclosure can provide an apparatus and a method capable of effectively providing services in a wireless communication system.

A device according to various embodiments of the disclosure may enable impedance matching with an antenna and a power amplifier and minimize loss by using a predetermined structure of a low noise amplifier including parallel resonant inductors, although an additional element for a switch between the power amplifier and the low noise amplifier is not disposed.

Advantageous effects obtainable from the disclosure may not be limited to the above-mentioned effects, and other effects which are not mentioned herein may be clearly understood from the following description by those skilled in the art to which the disclosure pertains.

[Brief Description of Drawings]

FIG. 1 illustrates a wireless communication system according to various embodiments of the disclosure.

FIG. 2 illustrates a diagram illustrating various structures of a front end of a radio frequency integrated circuit (RFIC) including an amplifier and a switch according to various embodiments of the disclosure.

FIG. 3 illustrates a diagram illustrating a structure of a front end of an RFIC and a low noise amplifier including parallel resonant inductors according to various embodiments of the disclosure.

FIG. 4A illustrates a diagram illustrating a portion of a low noise amplifier including parallel resonant inductors according to various embodiments of the disclosure.

FIG. 4B illustrates a diagram illustrating an example of a parallel resonant inductor structure according to various embodiments of the disclosure.

FIG. 5A illustrates a diagram illustrating an equivalent circuit of a portion of an RFIC, in the case of signal reception, according to various embodiments of the disclosure.

FIG. 5B illustrates a diagram illustrating an equivalent circuit of a portion of an RFIC, in the case of signal transmission, according to various embodiments of the disclosure.

FIG. 6A illustrates an example of a graph illustrating impedance of a low noise amplifier including parallel resonant inductors, according to various embodiments of the disclosure.

FIG. 6B illustrates an example of a graph illustrating performance of a low noise amplifier including parallel resonant inductors, according to various embodiments of the disclosure.

FIG. 7 illustrates a diagram illustrating a functional configuration of an electronic device according to various embodiments of the disclosure.

[Mode for the Invention]

The terms used in the disclosure are used merely to describe particular embodiments, and may not be intended to limit the scope of other embodiments. A singular expression may include a plural expression unless they are definitely different in a context. The terms used herein, including technical and scientific terms, may have the same meaning as those commonly understood by a person skilled in the art to which the disclosure pertains. Such terms as those defined in a generally used dictionary may be interpreted to have the meanings equal to the contextual meanings in the relevant field of art, and are not to be interpreted to have ideal or excessively formal meanings unless clearly defined in the disclosure. In some cases, even the term defined in the disclosure should not be interpreted to exclude embodiments of the disclosure.

Hereinafter, various embodiments of the disclosure will be described based on an approach of hardware. However, various embodiments of the disclosure include a technology that uses both hardware and software, and thus the various embodiments of the disclosure may not exclude the perspective of software.

In the following description, terms referring to electronic device components (e.g., board structure, substrate, printed circuit board (PCB), flexible PCB (FPCB), module, antenna, antenna element, circuit, processor, chip, element, and device), terms referring to component shapes (e.g., structural body, structure, support, contact, protrusion, and opening), terms referring to connections between structures (e.g., connection line, feeding line, connection, contact, feeding point, feeding unit, support, contact structure, conductive member, and assembly), terms referring to circuits (e.g., PCB, FPCB, signal line, feeding line, data line, RF signal line, antenna cable, RF path, RF module, and RF circuit), and the like are illustratively used for the sake of descriptive convenience. Therefore, the disclosure is not limited by the terms as described below, and other terms referring to subjects having equivalent technical meanings may be used. In addition, as used below, such term as "... unit", "... device", "... material", or "... body" may imply at least one shape structure or a unit for processing a function.

An electronic device that uses a mmWave band signal may include a radio frequency integrated circuit (RFIC) for signal processing. In this instance, in the RFIC, an antenna and a switch for selectively switching between a power amplifier (PA) and a low noise amplifier (LNA) in an amplifier (e.g., cascode amplifier or differential amplifier) may be disposed. The switch disposed between the power amplifier and the low noise amplifier and switching between them may be referred to as an antenna switch. For impedance matching between elements in the RFIC, an additional element (e.g., capacitor) corresponding to the antenna switch may be further disposed matched. However, when elements for impedance matching are additionally disposed, loss caused by the added elements may occur and the efficiency of the electronic device may be decreased.

Hereinafter, the disclosure may propose a structure that performs impedance matching without an additional switching element disposed for a low noise amplifier, by disposing parallel resonant inductors in the low noise amplifier, thereby minimizing loss. By including the parallel resonant inductors in the low noise amplifier, the disclosure enables the low noise amplifier to perform both signal amplification and switching, and thus may minimize loss.

In this instance, the structure according to the disclosure is not limited thereto. For example, according to an embodiment of the disclosure, the disclosure may include a structure in which parallel resonant inductors are disposed in a location that is not restricted, such as, in a front side or rear side of an input/output direction of a low noise amplifier, if the parallel resonant inductors are included in the low noise amplifier. As another example, according to an embodiment of the disclosure, an RFIC including a low noise amplifier in which parallel resonant inductors are disposed, may include a switch (e.g., antenna switch) for switching between a power amplifier and the low noise amplifier instead of, or in addition to, a switch that is connected with the power amplifier in series. As another example, according to an embodiment of the disclosure, a parallel resonant inductor structure disposed in a low noise amplifier may include three or more inductors as well, not just two inductors in a resonant state. Hereinafter, for ease of description, a description will be provided based on an RFIC including two inductors disposed in parallel in a low noise amplifier structure.

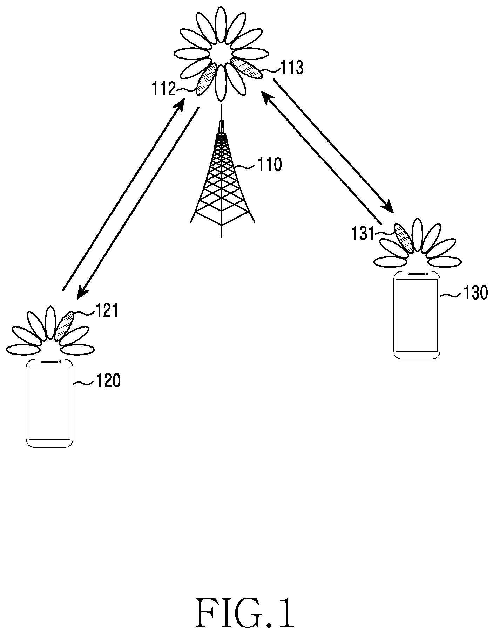

FIG. 1 illustrates a wireless communication system according to various embodiments of the disclosure. FIG. 1 illustrates a base station 110, a user equipment (UE) 120, and a UE 130 as some of nodes using radio channels in a wireless communication system. Although FIG. 1 illustrates only one base station, other base stations identical or similar to the base station 110 may be further included.

The base station 110 is a network infrastructure which provides radio access to the terminals 120 and 130. The base station 110 has coverage which is defined as a certain geographical area, based on a distance over which a signal can be transmitted. The base station 110 may be referred to as an "access point (AP)", an "eNodeB (eNB)", "5th generation node (5G node)", "wireless point", "transmission/reception point (TRP)", or other terms having technical meanings equivalent thereto, in addition to as a base station.

Each of the UE 120 and the UE 130 is a device used by a user and performs communication with the base station 110 through a wireless channel. In some cases, at least one of the UE 120 and the UE 130 may be operated without a user's involvement. That is, at least one of the UE 120 and the UE 130 may be a device performing machine type communication (MTC), and may not be carried by a user. The UE 120 and the UE 130 may each be referred to as a "user equipment (UE)", a "mobile station", a "subscriber station", a "customer-premises equipment (CPE)", a "remote terminal", a "wireless terminal", an "electronic device", a "user device", or other terms having technical meanings equivalent thereto, in addition to as a terminal.

The base station 110, the UE 120, and the UE 130 may transmit and receive wireless signals in millimeter wave (mmWave) bands (e.g., 28GHz, 30GHz, 38GHz, 60GHz). In this regard, in order to improve a channel gain, the base station 110, the UE 120, and the UE 130 may perform beamforming. The beamforming may include transmission beamforming and reception beamforming. That is, the base station 110, the UE 120, and the UE 130 may apply directivity to transmission signals or reception signals. To this end, the base station 110 and the UEs 120 and 130 may select serving beams 112, 113, 121, and 131 via a beam search procedure or a beam management procedure. After the serving beams 112, 113, 121, and 131 are selected, subsequent communication may be performed through a resource having a quasi co-located (QCL) relationship with a resource having transmitted the serving beams 112, 113, 121, and 131.

According to an embodiment of the disclosure, a structure of a low noise amplifier including parallel resonant inductors and a structure of an RFIC including the same may be used in an electronic device that transmits or receives a mmWave band signal. For example, in the case in which a base station 110 of FIG. 1 transmits or receives a mmWave band signal, a low noise amplifier or an RFIC disposed in the base station 110 may be configured as a structure of a low noise amplifier or RFIC according to an embodiment of the disclosure. As another example, in the case in which user equipments (UEs) 120 and 130 of FIG. 1 transmit or receives a mmWave band signal, a low noise amplifier or an RFIC disposed in the UEs 120 and 130 may be configured as a structure of a low noise amplifier or RFIC according to an embodiment of the disclosure.

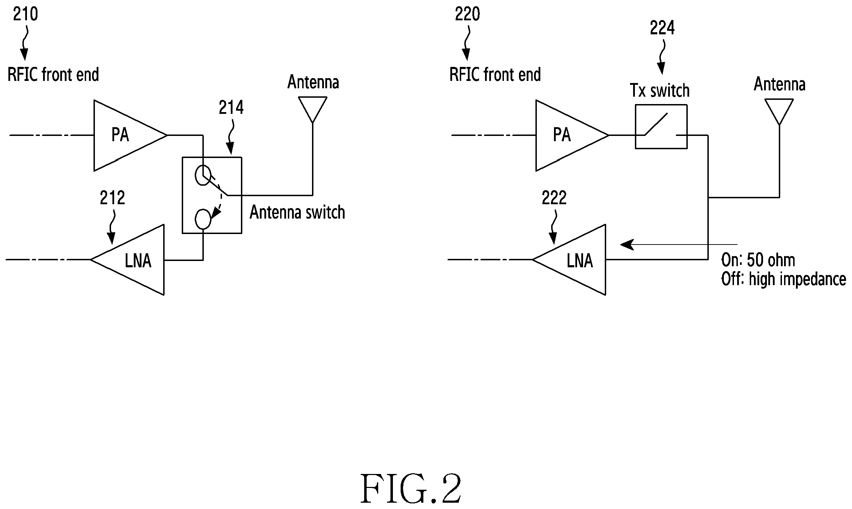

Hereinafter, in FIG. 2, an RFIC front end structure including parallel resonant inductors according to an embodiment of the disclosure will be described in comparison with a general RFIC front end structure including an antenna switch.

FIG. 2 illustrates a diagram illustrating various structures of a front end of a radio frequency integrated circuit (RFIC) including an amplifier and a switch, according to various embodiments of the disclosure. Specifically, FIG. 2 illustrates an RFIC front end structure 210 including an antenna switch that switches between a power amplifier and a low noise amplifier, and an RFIC front end structure 220 in which parallel resonance inductors are disposed in a low noise amplifier without an antenna switch.

Referring to FIG. 2, the RFIC front end structure 210 may include an antenna switch 214 that is disposed between a power amplifier and a low noise amplifier 212 and switches connections with an antenna. More particularly, the RFIC front end 210 for time division duplex (TDD) may include a structure in which the antenna switch 214 is disposed for switching between the power amplifier and the low noise amplifier 212 for a connection with the antenna so that matching isolation between the power amplifier and the low noise amplifier 212 may be easily secured. Here, matching may be impedance matching that is a method for reducing reflection due to a difference in impedance between two different connection ends when connecting an input end and an output end.

According to various embodiments of the disclosure, the front end structure 210 may easily perform isolation for impedance matching of each amplifier stage, and may have a high degree of freedom from the perspective of a design. In this instance, the antenna switch 214 may further need an additional element (e.g., capacitors connected in parallel or the like) for each amplifier for a switching function, and thus an additional path loss may occur and a noise figure may deteriorate. In addition, from the perspective of a design, an isolator that performs a role for fixing a power flow or a circulator for embodying an isolator may need to be disposed the outside, and thus an additional loss occurs and a required area is needed, and the performance of transmission or reception of the whole system may deteriorate.

Referring to FIG. 2, the RFIC front end structure 220 may include a power amplifier, a low noise amplifier 222, and a single serial switch 224 (hereinafter, transmission switch for ease of description) connected with the power amplifier in series. Particularly, in the RFIC front end structure 220, an antenna switch directly connected with the low noise amplifier is not disposed. Instead, the low noise amplifier including parallel resonant inductors may be included and the low noise amplifier itself having a parallel resonant characteristic may act a role of the antenna switch.

According to various embodiments of the disclosure, the RFIC front end structure 220 may include the single serial switch 224 disposed in a transmission path and the low noise amplifier 222 having a parallel resonant structure that utilizes mutual coupling in a reception path. According to an embodiment, in the case of signal reception, the transmission switch 224 may perform an off operation, the power amplifier may be in an off state, and the low noise amplifier 222 including parallel resonant inductors may have a predetermined impedance value (e.g., generally designed to be 50Ω (ohm) for impedance matching) and may be impedance-matched with an antenna. Conversely, in the case of signal transmission, the transmission switch 224 may perform an on operation, the power amplifier may be in an on state and performs a signal amplification function, and the low noise amplifier 222 including parallel resonant inductors may act similarly to when it is in an off state since resistance with a significantly high value is induced. As described above, according to the RFIC front end structure 220, the low noise amplifier 222 including parallel resonant inductors may perform both a low noise amplifier function and an antenna switch function. In addition, the low noise amplifier 222 including a parallel resonant structure may replace the antenna switch in the reception path, and the single serial switch 224 in the transmission path may be disposed and thus loss in the transmission path may be minimized.

According to various embodiments of the disclosure, an RFIC front end structure or a low noise amplifier structure including a parallel resonant structure are not limited to the above-described embodiments, and may include various structures when the structures have substantially the same or similar purposes or effects. For example, an RFIC front end may include an antenna switch, and may further include a low noise amplifier having a parallel resonant structure so that a switching or amplifying function is more efficiently performed. In addition, according to an embodiment, a resonant structure in a low noise amplifier may also include various cases in which elements that are generally exist in a low noise amplifier are disposed in a predetermined structure including a parallel structure and show a resonant characteristic.

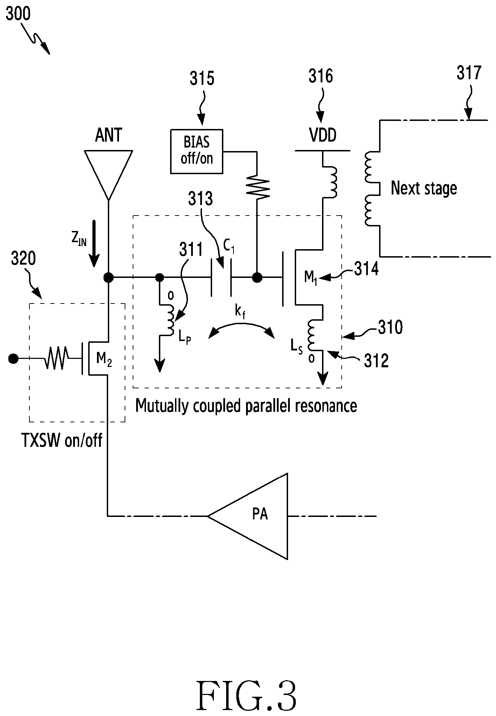

FIG. 3 illustrates a diagram illustrating a structure of a front end of an RFIC and a low noise amplifier including parallel resonant inductors, according to various embodiments of the disclosure. More specifically, FIG. 3 illustrates a detailed circuit diagram of the structure of the RFIC front end 220 of FIG. 2.

Referring to FIG. 3, an RFIC front end structure 300 may include a detailed circuit diagram of an antenna, a power amplifier, a transmission switch 320, and a low noise amplifier. According to an embodiment, in the low noise amplifier, a structure 310 including parallel resonant inductors, a bias element 315 for supplying power, a drain power source (voltage drain (VDD)) 316 for supplying power, a next stage 317 for amplification, or the like may be disposed. According to an embodiment, the mutually coupled parallel resonant structure 310 may include inductors 311 and 312 that are connected in parallel and are in a resonant state, and inductors in the parallel resonant state may include dots that are in opposite directions. That is, the inductors may have magnetic fields in directions opposite to each other, and mutual induced voltage polarities due to inductor currents may be in different directions. In addition, a coupling factor of the inductors in the resonant state may be $K_f$, and the coupling factor may be inversely proportional to a product of the inductances of the inductors. According to an embodiment, the mutually coupled parallel resonant structure 310 may further include a capacitor ($C_1$) 313, and the capacitor 313 may be disposed to avoid short circuit caused by an on/off operation of a bias element. In addition, the mutually coupled parallel resonant structure 310 may further include a first transistor ($M_1$) 314 for signal amplification, and the low noise amplifier may perform a function similar to an antenna switch according to the first transistor's on/off operation for amplification.

According to various embodiments of the disclosure, the low noise amplifier structure disposed in the reception path may have high impedance when it is in the off state, and thus, may perform a function similar to an antenna switch. According to an embodiment, the transmission switch 320 disposed in the reception path is only associated with the on/off state of the power amplifier, and thus a switch function may be performed using only a second transistor ($M_2$) disposed in series, without parallel transistors. In addition, the transmission switch 320 does not include parallel inductors, and thus, in the case of signal reception, it may be considered for impedance matching of the RFIC front end structure 300, together with the power amplifier's off-state impedance. According to an embodiment, in the case of signal transmission, the second transistor ($M_2$) may not need a large channel width since breakdown does not occur. Accordingly, if it is considered for impedance matching together with the power amplifier's off-state impedance even in the case of signal reception, a path loss or deterioration of performance in matching may not be high. In this instance, according to an embodiment, loss may be different depending on an individual characteristic of the power amplifier's off-state impedance. For example, an off-state output impedance of a power amplifier of a class AB type may be generally higher than an off-state output impedance of a power amplifier of a Doherty type. Therefore, based on the characteristic, according to various embodiments of the disclosure, at least one of the various types of power amplifiers (e.g., class AB type, Doherty type) may be selected and disposed for impedance matching.

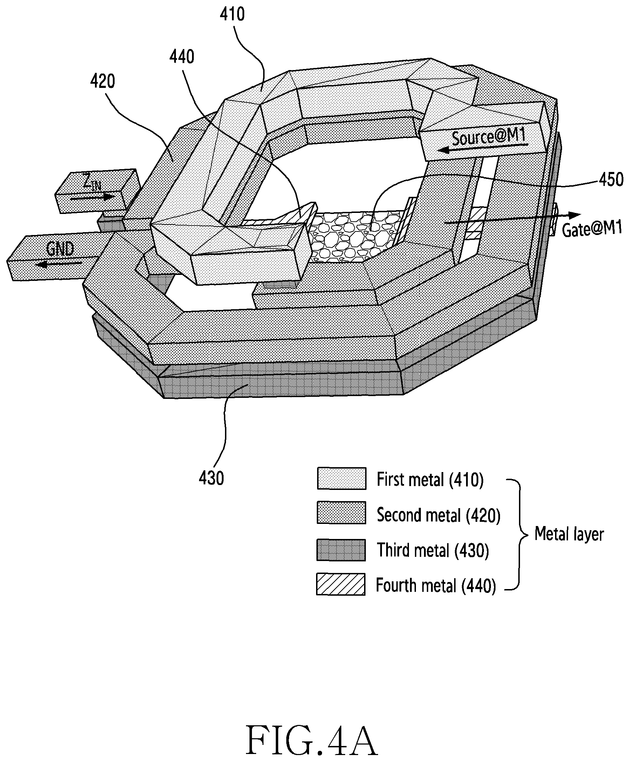

FIG. 4A illustrates a diagram illustrating a portion of a low noise amplifier including parallel resonant inductors, according to various embodiments of the disclosure. Specifically, FIG. 4A is an oblique view of an inductor or capacitor made of individual metals. According to an embodiment, the structure illustrated in FIG. 4A may correspond to the structure that configures $L_p$ 311, $L_s$ 312, and $C_1$ 313 of FIG. 3. For example, the structure illustrated in FIG. 4A may be a diagram illustratively embodies a mutually coupled parallel resonant circuit structure, excluding the first transistor ($M_1$).

Referring to FIG. 4A, the parallel resonant structure may include a first inductor ($L_s$) and a second inductor ($L_p$) that are disposed in parallel and are in a resonant state. In addition, the parallel resonant structure may further include a capacitor ($C_1$) 450 disposed to avoid short circuit caused by an on/off operation of a bias element. According to an embodiment, each of the first inductor and the second inductor may be provided in a spiral form by using two metal layers. When a parallel resonant structure is provided, in which parallel resonant inductors are provided in a spiral form and the capacitor ($C_1$) 450 is disposed therebetween, an area occupied by each inductor and capacitor is minimized and maintain the parallel resonant state. Specifically, from the perspective of operation of a high-frequency RFIC, the structure may clearly specify a return current path, and thus may increase stability of the circuit.

According to an embodiment, the first inductor ($L_s$) may be provided by horizontally disposing a first metal layer 410 and a second metal layer 420. The first metal layer 410 may receive an electric charge carrier from a source of the first transistor ($M_1$). The second metal layer 420 may be connected with the ground, acting as a ground. According to an embodiment, an induced voltage polarity may be caused by a magnetic field generated when a current flows through the first metal layer 410 and the second metal layer 420.

According to an embodiment, the second inductor ($L_p$) may be provided by horizontally disposing the second metal layer 420 and a third metal layer 430. The second metal layer 420 may be connected with the ground, acting as a ground. According to an embodiment, an induced voltage polarity may be caused by a magnetic field generated when a current flows through the second metal layer 420 and the third metal layer 430. According to an embodiment, the induced voltage polarity caused by the second inductor ($L_p$) may be opposite to the induced voltage polarity caused by the first inductor ($L_s$).

According to an embodiment, the capacitor ($C_1$) 450 may be provided by being attached to a fourth metal layer 440, and the fourth metal layer 440 may transfer an electric charge carrier to a gate of the first transistor ($M_1$).

According to an embodiment, the structure disclosed in FIG. 4A may be a structure embodied to minimize the occupied area and to ensure the stability of the circuit. In this instance, according to various embodiments of the disclosure, the disclosure is not limited to the above-described example and may include various structures, according to implementation such as minimizing an effect that each inductor exerts on one another irrespective of an area, adjusting a coupling factor, or the like.

According to an embodiment, for example, various materials, in addition to metal, may be used for the capacitor ($C_1$) 450 or the first to fourth metal layers 410, 420, 430, and 440. According to an embodiment, in consideration of characteristics of efficiently transmitting or receiving a current, having low reactivity, and enduring a high temperature, various materials may include various semi-conductor materials, polysilicon that is disposition-staked on an oxide film, or the like.

According to an embodiment, in consideration of a disposition of various elements in a low noise amplifier, for diversity of a circuit structure, the first inductor ($L_s$), the second inductor ($L_p$), or the capacitor 450 may be disposed horizontally in a different order from the structure of FIG. 4A, or in consideration of an effect that the capacitor may exert on the parallel resonant characteristic of inductors, a parallel resonant structure may be provided by disposing the capacitor ($C_1$) 450 separately from the inductors.

According to an embodiment, an inductive coupling characteristic for a parallel resonant characteristic is caused by a magnetic field between inductors, and the characteristic may be changed based on a distance between the inductors. Therefore, each inductor may be a predetermined distance spaced apart in order to adjust a coupling factor or various variables for impedance matching, irrespective of an occupied area in a circuit, as long as the parallel resonant state is included.

According to an embodiment, not only two inductors, but also three or more inductors may be mutually coupled for the parallel resonant characteristic. Therefore, if a parallel resonant structure is capable of including three or more inductors and a portion or the whole of the inductors are disposed in parallel and are in the parallel resonant state, the parallel resonant structure is not limited to the above-described example, and may be included in various embodiments of the disclosure.

As described above, a parallel resonant structure including a low noise amplifier according to various embodiments of the disclosure is not limited to the example of FIG. 4A and may include variously embodied structures, if the structure has a characteristic in which each inductor is in the resonant state and high impedance is caused as a current flows.

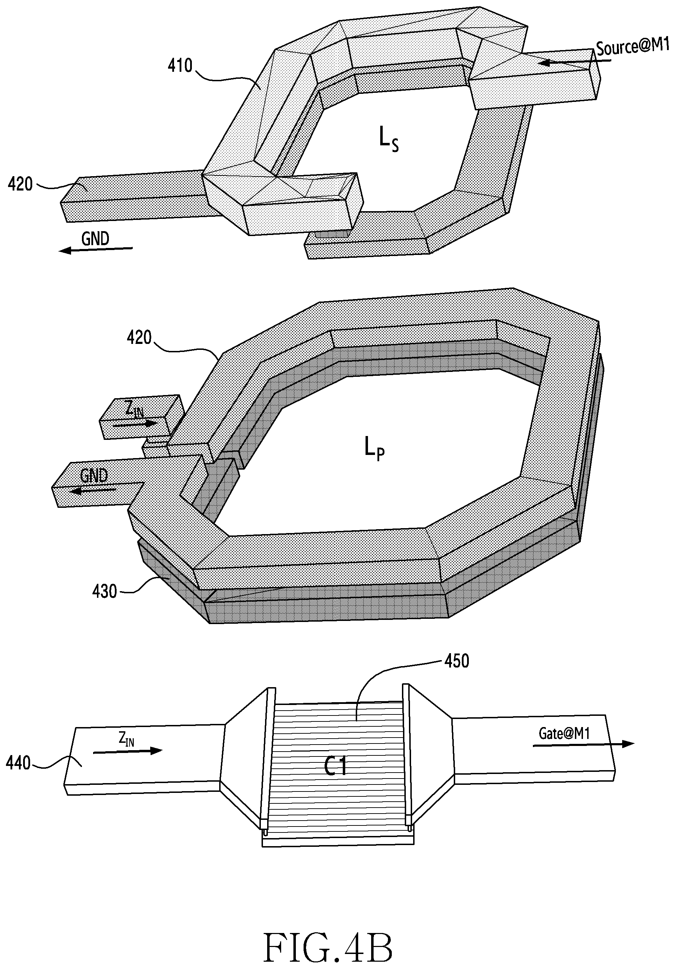

FIG. 4B illustrates a diagram illustrating an example of a parallel resonant inductor structure according to various embodiments of the disclosure. More particularly, FIG. 4B respectively illustrates metal layers and capacitor 450 in the parallel resonant structure of FIG. 4A.

According to an embodiment, the first inductor ($L_s$) may be provided by horizontally disposing the first metal layer 410 and the second metal layer 420. The first metal layer 410 may receive an electric charge carrier from the source of the first transistor ($M_1$). The second metal layer 420 may be connected with the ground, acting as a ground. According to an embodiment, an induced voltage polarity may be caused by a magnetic field generated when a current flows through the first metal layer 410 and the second metal layer 420. According to an embodiment, the second metal layer 420 may be shared by the first inductor ($L_s$) and the second inductor ($L_p$).

According to an embodiment, the second inductor ($L_p$) may be provided by horizontally disposing the second metal layer 420 and the third metal layer 430. The second metal layer 420 may be connected with the ground, acting as a ground. According to an embodiment, an induced voltage polarity may be caused by a magnetic field generated when a current flows through the second metal layer 420 and the third metal layer 430. According to an embodiment, the induced voltage polarity caused by the second inductor ($L_p$) may be opposite to the induced voltage polarity caused by the first inductor ($L_s$).

According to an embodiment, the capacitor ($C_1$) 450 may be provided by being attached to the fourth metal layer 440, and the fourth metal layer 440 may transfer an electric charge carrier to the gate of the first transistor ($M_1$).

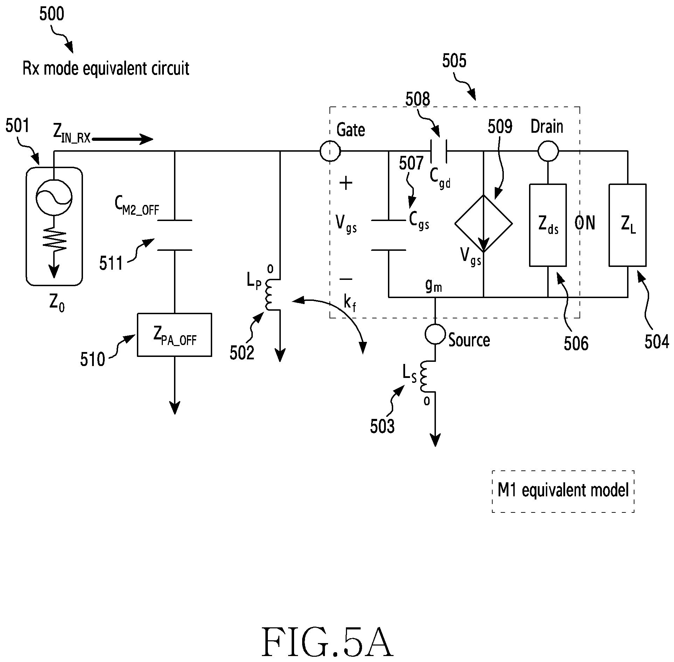

FIG. 5A illustrates a diagram illustrating an equivalent circuit of a portion of an RFIC, in the case of signal reception, according to various embodiments of the disclosure. Specifically, FIG. 5A illustrates a detailed equivalent circuit for impedance matching of an RFIC front end in the case of signal reception.

According to various embodiments of the disclosure, FIG. 5A illustrates an equivalent circuit 500 of an RFIC front end in a signal reception (e.g., Rx) mode. The equivalent circuit 500 of the RFIC front end of the signal reception mode may include antenna impedance 501, output impedance 510, a parasitic capacitor 511, inductors 502 and 503 inductively coupled for a parallel resonant state, a first transistor equivalent model 505, and a load impedance 504.

According to an embodiment, the antenna impedance 501 may be $Z_0$. In addition, in the case of signal reception, input impedance of a front end circuit may be $Z_{IN\_Rx}$. According to an embodiment, $Z_{in\_Rx}$ may be impedance including $Z_{PA\_OFF}$ 510 that is output impedance when a power amplifier is in an off state and the parasitic capacitor ($C_{M2\_OFF}$) 511 when the second transistor is in an off state. That is, in the case of signal reception, the power amplifier's off-state impedance may be included in the impedance of the lower noise amplifier and may be used for impedance matching of the low noise amplifier.

According to an embodiment, in the case signal reception, a first transistor ($M_1$) may be in an on state. In the case of signal reception mode, an equivalent model of the first transistor ($M_1$) 505 may include a gate-to-source capacitor ($C_{gs}$) 507, a gate-to-source dependent voltage source ($V_{gs}$) 509, a gate-to-drain capacitor ($C_{gd}$) 508, and a drain-to-source impedance ($Z_{ds}$) 506.

According to various embodiments of the disclosure, a circuit of an RFIC front end for ideal impedance matching may be embodied as shown below.

According to an embodiment, in the case of signal reception for impedance matching, $Z_{IN\_Rx}$ and $Z_0$ may be designed to be substantially the same. According to an embodiment, capacitors ($C_1$ (not illustrated) and $C_{gd}$ 509) that actually exist for preventing short circuit caused by a bias power source may be excluded when interpreting impedance matching since they exert an insignificant effect on the impedance matching. In addition, for ease of arithmetical calculation, it is assumed that the parallel resonant inductors 502 and 503 have the same inductance value, and a coupling factor ($k_f$) of the parallel resonant inductors is 1, and the impedance 506 of the first transistor ($M_1$) has the same input/output impedance value irrespective of the on or off state. The load impedance $Z_L$ 504 of the low noise amplifier may be an element which is an essential condition for impedance matching in the case of signal reception, and a return loss may be designed to be less than or equal to -10dB (e.g., voltage standing wave ratio (VSWR) < 1.925) that generally indicates a good quality.

According to an embodiment, in the case of signal reception, when the RFIC circuit 500 including the first transistor ($M_1$) 505 is expressed in terms of an S parameter, it may be expressed as $S = \begin{bmatrix} S_{11} & S_{12} \\ S_{21} & S_{22} \end{bmatrix}$. Here, $S_{ab}$ may be a value ($S_{ab} = \dfrac{V_a}{V_b}$) obtained by dividing an output voltage by an input voltage. The S parameter may be a ratio of an output voltage to an input voltage in the distribution of frequencies, and may be a parameter used for analyzing a characteristic of a radio frequency (RF) circuit by using a relative value between input and output signals.

According to an embodiment, under the above-described conditions, for impedance matching, a reflection coefficient ($\Gamma$) may be introduced. The reflection coefficient may be an index calculated by means of a ratio of a reflected voltage to an input voltage so as to indicate the amount of reflection occurring due to a difference in impedance, and may be expressed as $\Gamma = \dfrac{Z_L - Z_0}{Z_L + Z_0}$. According to an embodiment, when a reflection coefficient value is low, it indicates that the amount of reflection is low and impedance is matched well. According to an embodiment, when impedance matching is perfectly performed, it indicates that no reflection occurs at an input end and a load end, and the circuit is capable of providing maximum power efficiency. In this instance, no reflection may not be possible in an actual circuit, and a return loss may be a value obtained by converting a reflection coefficient occurring in this instance into a log scale (dB) of power. That is, it may be expressed as *Return Loss(dB)* = -10*log*$|\Gamma|^2$ = -20*log*$|\Gamma|$. Therefore, this may indicate that the amount of reflection is lower as the absolute value of a return loss is larger, and thus may indicate that impedance is matched well. As another reflection index, a voltage standing wave ratio (VSWR) may be introduced. The VSWR refers to a ratio of a voltage of a maximum amplitude and a voltage of a minimum amplitude, and may be expressed as $VSWR = \frac{1+|\Gamma|}{1-|\Gamma|}$. That is, the most ideal VSWR value may be 1, and it indicates that the amount of reflection may be increased as the VSWR is higher and impedance matching is beyond ideal impedance matching.

As described above, for efficient impedance matching, input impedance may be designed so that the amount of reflection is less than or equal to a predetermined amount of reflection. For example, generally, to perform efficient impedance matching, an actual circuit may be designed so that the VSWR is less than 1.925. Under the above-described conditions, the value of an input impedance load may be calculated as shown below.

[Equation 1]

$$Z_{L\_calc} = Z_0 \frac{S_{12}S_{21} + (\Gamma_{IN} - S_{11})(S_{22} + 1)}{S_{12}S_{21} + (\Gamma_{IN} - S_{11})(S_{22} - 1)}$$

Here, in consideration of the above-described conditions, they may be expressed as $\Gamma_{IN} = |\Gamma_{IN}|e^{j\theta}$, $\begin{cases} |\Gamma_{IN}| < 0.32 \\ -\pi < \theta < \pi \end{cases}$, and $real(Z_{L\_calc}) > 0$.

According to an embodiment, in the case of signal reception in consideration of the load impedance calculated from the above equation, an input impedance value may be expressed as the following equation.

[Equation 2]

$$Z_{IN\_RX} = \cfrac{1}{\cfrac{1}{j\omega L} + j\omega 4C_{gs} + \cfrac{1}{Z_L + Z_{ds}} + \cfrac{1}{\cfrac{1}{2g_m}\left(1 + \cfrac{Z_L}{Z_{ds}}\right)} + \cfrac{1}{Z_{PA\_OFF} + \cfrac{1}{j\omega C_{OFF\_M2}}}}$$

According to an embodiment, values based on the above-described conditions and element values as shown below may be substituted into the formula for input impedance calculated from Equation 2.

[Table 1]

| Name | Value | Name | Value |
|---|---|---|---|
| $C_{gs}$ | 40 fF | $L_p, L_s$ | 220 pH |
| $C_{ds}$ | 30 fF | $k_f$ | 1 |
| $C_{gd}$ | $\infty$ | $Z_L$ | 402‖6.4fF |
| $g_m$ | 0.03 S | $C_{M2\_OFF}$ | 60fF |
| $Z_{ds}$ | 600‖30fF | $Z_{PA\_OFF}$ | 0 |

According to an embodiment, in the case of signal reception or signal transmission, all the above-mentioned element values may be substituted into an equivalent circuit of an RFIC. According to an embodiment, the following equation may be obtained by substituting the above-describe element values.

[Equation 3]

$$Z_{IN\_RX}\big|_{Z_L=Z_{L\_calc}(\omega_R),\omega=\omega_R} \approx Z_0$$

According to an embodiment, in the case of signal reception, a result of the interpretation of an input impedance value shows that the input impedance value may have a value substantially the same as an antenna impedance value. That is, in the case of signal reception, the equivalent circuit 500 of the RFIC front end may be designed to have a resonant characteristic caused by inductors connected in parallel. For example, input impedance may have a characteristic of a parallel resonant type, and may be shown as $Z_0$ in the case of signal reception.

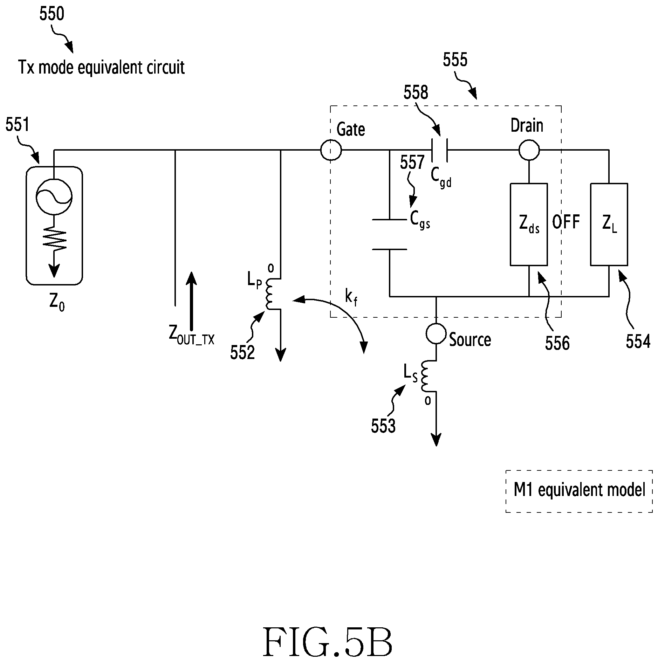

FIG. 5B illustrates a diagram illustrating an equivalent circuit of a portion of an RFIC, in the case of signal transmission, according to various embodiments of the disclosure. Specifically, FIG. 5B illustrates a detailed equivalent circuit for impedance matching of an RFIC front end in the case of signal transmission. According to an embodiment, the equivalent circuit of FIG. 5B may be the case in which a circuit same as the equivalent circuit of FIG. 5A is in a signal transmission mode.

According to various embodiments of the disclosure, FIG. 5B illustrates an equivalent circuit 550 of an RFIC front end in a signal transmission (e.g., Tx) mode. The equivalent circuit 550 of the RFIC front end of the signal transmission mode may include antenna impedance 551, inductors 552 and 553 inductively coupled for a parallel resonant state, a first transistor equivalent model 555, and load impedance 554.

According to an embodiment, the antenna impedance 551 may be $Z_0$. In addition, in the case of signal transmission, output impedance of the front end circuit may be $Z_{OUT\_Tx}$. According to an embodiment, $Z_{OUT\_Tx}$ is the case in which a power amplifier is in an on state, and may be impedance made by the antenna impedance 551 and a low noise amplifier's off impedance in series.

According to an embodiment, in the case signal transmission, a first transistor ($M_1$) may be in an off state. In the case of signal transmission mode, the equivalent model of the first transistor ($M_1$) 555 may include a gate-to-source capacitor ($C_{gs}$) 557, a gate-to-drain capacitor ($C_{gd}$) 558, and a drain-to-source impedance ($Z_{ds}$) 556. In this instance, a bias power source for low noise amplification is off, and thus a gate-to-source voltage may not be applied.

According to various embodiments of the disclosure, a circuit of an RFIC front end for ideal impedance matching may be embodied as shown below.

According to an embodiment, for impedance matching, $Z_{OUT\_Tx}$ and $Z_0$ may be designed to be substantially the same in the case of signal reception. According to an embodiment, capacitors ($C_1$ (not illustrated) and $C_{gd}$ 559) that actually exist for preventing short circuit caused by a bias power source may be excluded when interpreting impedance matching since they exert an insignificant effect on the impedance matching. In addition, for ease of arithmetical calculation, it is assumed that the parallel resonant inductors 552 and 553 have the same inductance value, and a coupling factor ($k_f$) of the parallel resonant inductors is 1, and the impedance 556 of the first transistor ($M_1$) has the same input/output impedance value irrespective of the on or off state. The load impedance $Z_L$ 554 of the low noise amplifier may be designed so that a return loss is to be less than or equal to -10dB (e.g., voltage standing wave ratio (VSWR) < 1.925) that generally indicates a good quality.

According to an embodiment, in the case of signal reception, when the RFIC circuit 550 including the first transistor ($M_1$) 555 is expressed in terms of an S parameter, it may be expressed as $S = \begin{bmatrix} S_{11} & S_{12} \\ S_{21} & S_{22} \end{bmatrix}$. Here, $S_{ab}$ may be a value ($S_{ab} = \frac{V_a}{V_b}$) obtained by dividing an output voltage by an input voltage. The S parameter may be a ratio of an output voltage to an input voltage, and may be a parameter used for characteristic analysis of a radio frequency (RF) circuit by using a relative value between input and output signals.

According to an embodiment, under the above-described conditions, a reflection coefficient ($\Gamma$) may be introduced for impedance matching. The reflection coefficient may be an index calculated by means of a ratio of a reflected voltage to an input voltage so as to indicate the amount of reflection occurring due to a difference in impedance, and may be expressed as $\Gamma = \frac{Z_L - Z_0}{Z_L + Z_0}$. According to an embodiment, when a reflection coefficient value is low, it indicates that the amount of reflection is low and impedance is matched well. According to an embodiment, when impedance matching is perfectly performed, it indicates that no reflection occurs at an input end and a load end, and the circuit is capable of providing maximum power efficiency. In this instance, no reflection may not be possible in an actual circuit, and a return loss may be a value obtained by converting a reflection coefficient occurring in this instance into a log scale (dB) of power. That is, it may be expressed as *Return Loss(dB)* = -10*log*|$\Gamma$|$^2$ = -20*log*|$\Gamma$|. Therefore, this may indicate that the amount of reflection is lower as the absolute value of a return loss is larger, and thus may indicate that impedance is matched well. As another reflection index, a voltage standing wave ratio (VSWR) may be introduced. The VSWR refers to a ratio of voltage of a maximum amplitude and a voltage of a minimum amplitude, and may be expressed as $VSWR = \frac{1+|\Gamma|}{1-|\Gamma|}$. That is, the most ideal VSWR value may be 1, and the amount of reflection is increased as the VSWR is increased, and this means that impedance matching is beyond the ideal impedance matching.

As described above, in order to perform efficient impedance matching, output impedance may be designed so that the amount of reflection is a value less than or equal to a predetermined amount of reflection. According to an embodiment, a load impedance value calculated in consideration of the above-described conditions may be the same as the equation of FIG. 5A.

According to an embodiment, in the case of signal transmission in consideration of the load impedance calculated as described above, an output impedance value may be expressed by the following equation.

[Equation 4]

$$Z_{OUT\_TX} = \frac{1}{\frac{1}{j\omega L} + j\omega 4 C_{gs} + \frac{1}{Z_L + Z_{ds}} + \frac{1}{Z_0}}$$

According to an embodiment, values based on the above-described conditions and specific element values may be substituted into the formula of the output impedance calculated from Equation 4, and the equivalent circuit of the RFIC front end is the circuit same as FIG. 5A and thus, the values same as the values in Table 1 of FIG. 5A may be used.

That is, in the case of signal reception or signal transmission, all the above-mentioned element values of Table 1 may be substituted into an equivalent circuit of the RFIC. According to an embodiment, the following equation may be obtained by substituting the above-describe element values.

[Equation 5]

$$Z_{OUT\_TX}\Big|_{Z_L = Z_{L\_calc}(\omega_T), \omega = \omega_T} \approx Z_0$$

According to an embodiment, in the case of signal transmission, a result of interpretation of the output impedance value shows that the output impedance value may have a value substantially the same as an antenna impedance value. That is, in the case of signal transmission, the equivalent circuit 550 of the RFIC front end may be designed to have a resonant characteristic caused by inductors connected in parallel. For example, output impedance may have a characteristic of a parallel resonant type, and may be shown as $Z_0$ in the case of signal transmission.

As described above, FIGS. 5A and 5B illustrate designs for impedance matching of a front end structure of an RFIC that includes a low noise amplifier including parallel resonant inductors, and a switching transistor connected with a power amplifier in series. In this instance, according to various embodiments of the disclosure, the above-described structure is merely an example and the disclosure is not limited thereto, and may include various low noise amplifier structures with the parallel resonant characteristic. For example, in relation with a transistor impedance or load impedance of a low noise amplifier, a cascode structure that may stack transistors and increase (boost) impedance without any difficulty associated with a voltage headroom may be used. According to an embodiment, for the low noise amplifier, a differential amplifier structure that uses an inverting input terminal and non-inverting input terminal and amplifies a difference between two inputs may be used. According to an embodiment, for the low noise amplifier, a cascode differential amplifier structure that uses stacked transistors and a symmetrical structure may be used.

According to an embodiment, the RFIC front end structure may include a plurality of low noise amplifiers based on the above-described various low noise amplifier structures. In this instance, the RFIC front end structure may further include a transformer, and may utilize a transformer structure included in at least one low noise amplifier and may process an input signal in a distributed active transformer manner. A distributed active transformer may be used to generate a large amount of RF power by using a plurality of inductors and low noise transistors.

As described above, in consideration of input/output current and power, low noise amplification structures of various models may be configured, in addition to the transistor impedance or load impedance disposed in FIG. 5A and FIG. 5B. In this instance, it is a matter of course that, since resonant-state inductors are disposed in parallel in a low noise amplifier, and the low noise amplifier may have a resonant characteristic, the low noise amplifier may need to be capable of replacing the role of an antenna switch.

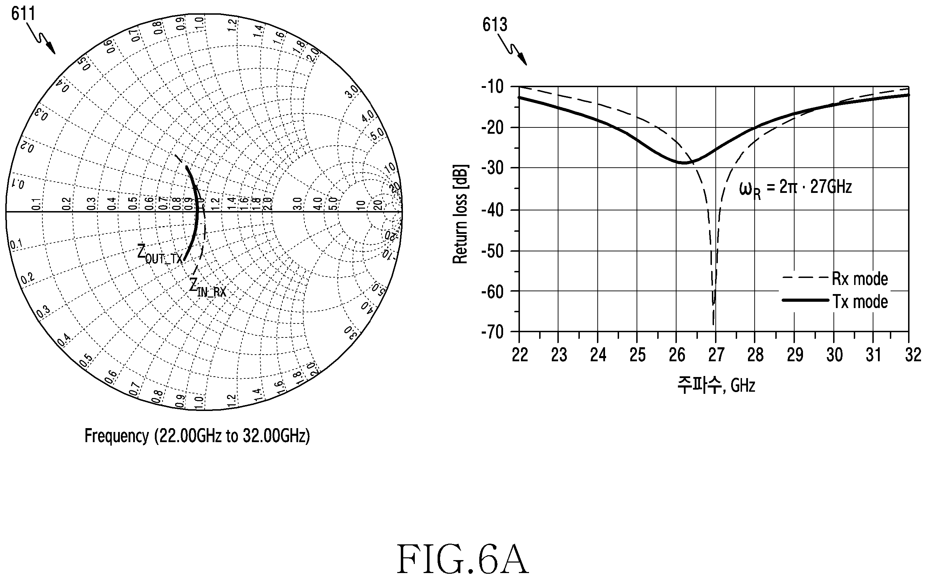

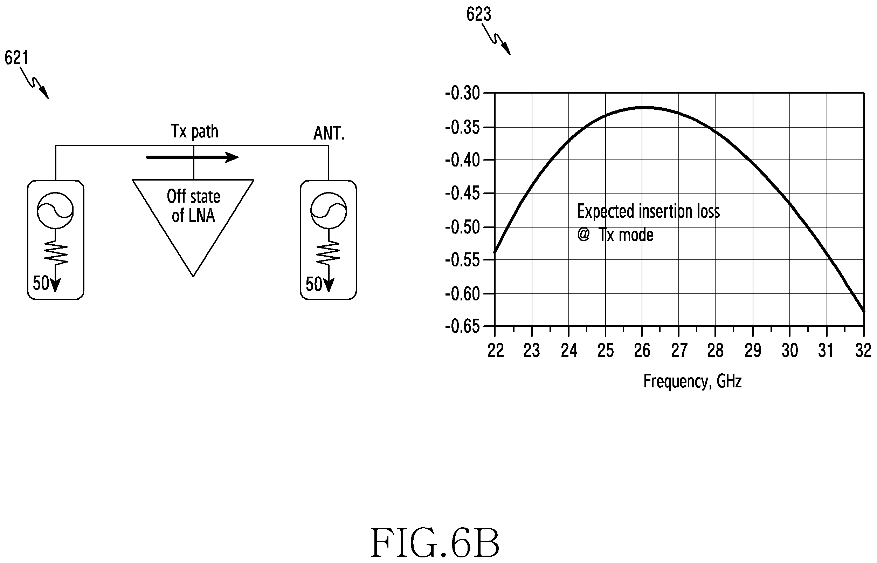

Hereinafter, FIG. 6A and FIG. 6B provide a description by comparing a characteristic based on a frequency band and a frequency characteristic, in the case of signal transmission or signal reception of an electronic device including a low noise amplifier and the low noise amplifier including inductors in a parallel resonant state, according to various embodiments of the disclosure.

FIG. 6A illustrates an example of a graph illustrating impedance of a low noise amplifier including parallel resonant inductors according to various embodiments of the disclosure. For ease of description, in FIG. 6A, it is assumed that element values of an RFIC front end have the element values and return loss described in FIGS. 5A and 5B.

According to an embodiment, a first graph 611 of FIG. 6A illustrates a smith chart based on a frequency bandwidth. In the case of signal transmission, a solid line of the first graph 611 may be a set of output impedance based on a frequency band. In the case of signal reception, a broken line of the first graph 611 may be a set of input impedance based on a frequency band. According to an embodiment, as a frequency band is increased from 22GHz to 32GHz, each input impedance or output impedance may be changed. In this instance, element values or VSWR value of the electronic device (e.g., RFIC front end) may be the values shown in FIG. 5A to 5B. According to an embodiment, load impedance may be designed so that a resonant frequency is to be 27GHz in the case of signal reception. According to an embodiment, as illustrated in the first graph 611, output impedance in the case of signal transmission may have an equivalent circuit simpler than input impedance in the case of signal reception, and thus may exert a less significant effect and may have a smaller change based on a frequency band.

According to an embodiment, a second graph 613 of FIG. 6A illustrates a return loss based on a frequency bandwidth. A horizontal axis of the second graph 613 of FIG. 6A may represent a frequency (unit, GHz) and a vertical axis of the second graph 613 may represent a return loss (unit, dB). According to an embodiment, in the case of signal transmission, a solid line of the second graph 613 may represent output impedance based on a frequency band. In the case of signal reception, a broken line of the second graph 613 may represent input impedance based on a frequency band. According to an embodiment, load impedance may be designed so that a resonant frequency is to be 27GHz in the case of signal reception.

FIG. 6B illustrates an example of a graph illustrating performance of a low noise amplifier including parallel resonant inductors according to various embodiments of the disclosure. For ease of description, in FIG. 6B, it is assumed that element values of an RFIC front end have the element values and return loss described in FIGS. 5A and 5B.

FIG. 6B illustrates a structure 621 in which a signal is transmitted from a power amplifier to an antenna along with a transmission path when the low noise amplifier is in an off state. Generally, in order to perform efficient impedance matching, an input end, a load end, or the like in an actual RF circuit may be matched to 50Ω(ohm).

According to an embodiment, a graph 623 of FIG. 6B illustrates an insertion loss based on a frequency bandwidth. A horizontal axis of the graph 623 of FIG. 6B may represent a frequency (unit: GHz) and a vertical axis of the graph 623 may represent an insertion loss (unit: dB). The insertion loss may be a signal power loss caused by insertion of an element into a circuit.

When an RFIC front end is designed according to various embodiments of the disclosure, an expected insertion loss in the transmission path may be less than or equal to 0.5dB in the frequency band ranging from 24GHz to 32GHz. As compared with the case in which an insertion loss caused by general transmission path elements (e.g., an insertion loss of a structure that uses an antenna switch) is 1dB, an insertion loss may be dramatically decreased by using a single switch connected with a power amplifier in series. In addition, in the case of signal reception, a separate switch for reception does not exist, and thus an additional insertion loss may not occur.

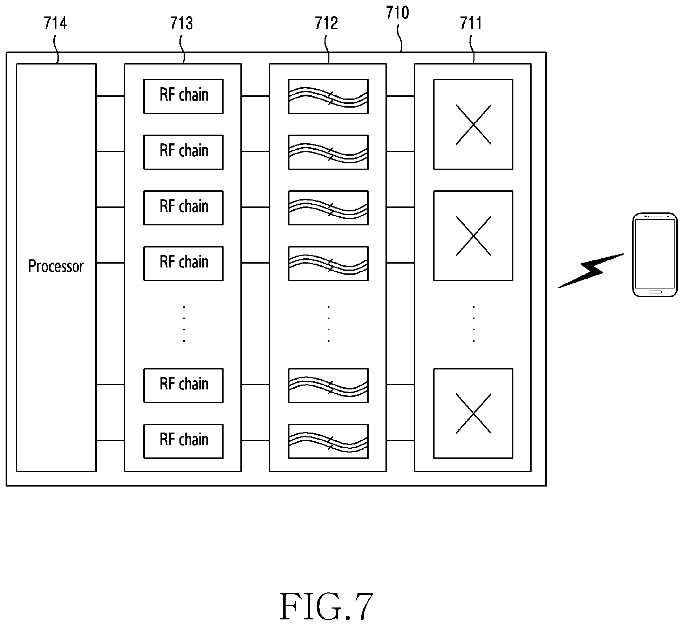

FIG. 7 is a diagram illustrating a functional configuration of an electronic device according to various embodiments of the disclosure.

FIG. 7 illustrates a functional configuration of an electronic device 710. The electronic device 710 may include an antenna unit 711, a filter unit 712, a radio frequency (RF) processor 713, and a controller 714.

The antenna unit 711 may include a plurality of antennas. An antenna may perform functions for transmitting or receiving a signal via a wireless channel. The antenna may include an emitter made of a conductor or conductive pattern provided on a substrate (e.g., a PCB). The antenna may emit an up-converted signal in a wireless channer, or may obtain a signal emitted from another device. Each antenna may be referred to as an antena element or antena device. In some embodiments, the antenna unit 711 may include an antenna array (e.g., sub array) in which a plurality of antenna elements are disposed in an array. The antenna unit 711 may be electrically connected to the filter unit 712 via RF signal lines. The antenna unit 711 may be embedded in a PCB including a plurality of antenna elements. The PCB may include a plurality of RF signals to connect respective antenna elements and the filters of the filter unit 712. The RF signals may be referred to as a feeding network. The antenna unit 711 may provide a received signal to the filter unit 712, or may emit a signal provided from the filter unit 712 to the air. The antenna given in the structure according to an embodiment of the disclosure may be included in the antenna unit 711.

According to various embodiments, the antenna unit 711 may include at least one antenna module having a dual-polarized antenna. The dual-polarized antenna may be, for example, a cross-pol (x-pol) antenna. A dual-polarized antenna may include two antenna elements corresponding to different polarizations from each other. For example, the dual-polarized antenna may have a first antenna element having a polarization of +45° and a second antenna element having a polarization of -45°. Not to mention that other orthogonal polarizations may also be used, in addition to the +45° and -45° polarizations. Each antenna element may be connected to a feeding line, and may be electrically connected to the filter unit 712, the RF processor 713, and the controller 714 which will be described later.

According to an embodiment, the dual-polarized antenna may be a patch antenna (or microstrip antenna). The dual-polarized antenna is in the form of a patch antenna, thereby facilitating the implementation of an array antenna and integration. Two signals having polarization different from each other may be input to antenna ports, respectively. Antenna ports may correspond to antenna elements, respectively. To achieve high efficiency, it is required to optimize the relationship with a co-pol characteristic and a cross-pol characteristic between the two signals having different polarization. In a dual-polarized antenna, a co-pol characteristic is a characteristic associated with a predetermined polarization component and a cross-pol characteristic is a characteristic associated with a polarization component, different from the predetermined polarization component.

The filter unit 712 may perform filtering in order to transfer a signal of an intended frequency. The filter unit 712 may perform a function for selectively identifying a frequency by forming resonance. According to embodiments, the filter unit 712 may form resonance via a cavity structurally including a dielectric. In addition, in some embodiments, the filter unit 712 may form resonance via elements that form inductance or capacitance. In addition, in some embodiments, the filter unit 712 may include an elastic filter such as a bulk acoustic wave (BAW) filter or a surface acoustic wave (SAW) filter. The filter unit 712 may include at least one of a band pass filter, a low pass filter, a high pass filter, or a band reject filter. That is, the filter unit 712 may include RF circuits for obtaining a signal of a frequency band for transmission and a frequency band for reception. The filter unit 712 according to various embodiments may electrically connect the antenna unit 711 and the RF processor 713.

The RF processor 713 may include a plurality of RF paths. An RF path may be a unit of a path through which a signal received via an antenna or a signal emitted via an antenna passes. At least one RF path may be referred to as an RF chain. An RF chain may include a plurality of RF elements. RF elements may include an amplifier, a mixer, an oscillator, a DAC, an ADC, or the like. For example, the RF processor 713 may include an up converter that up-converts a digital transmission signal of a baseband into a transmission frequency, and a digital-to-analog converter (DAC) that converts an up-converted digital transmission signal into an analog RF transmission signal. The up converter and the DAC may be a portion of a transmission path. The transmission path may further include a power amplifier (PA) or a coupler (or combiner). In addition, for example, the RF processor 713 may include an analog-to-digital converter (ADC) that converts an analog RF reception signal into a digital reception signal and a down converter that converts a digital reception signal into a digital reception signal in a baseband. The ADC and the down-converter may be a portion of a reception path. The reception path may further include a low-noise amplifier (LNA) or a coupler (or divider). The RF components of the RF processor may be embodied in a PCB. The antennas and the RF components of the RF processor may be embodied in a PCB, and filters between PCBs may be repetitively coupled with each other and a plurality of layers may be provided.

A structure of a low noise amplifier including parallel resonant inductors according to an embodiment of the disclosure may be included in the RF processor 713 of FIG. 7. That is, the RF processor 713 may include a radio frequency integrated circuit (RFIC) as an RF element for mmWave. According to an embodiment, the low noise amplifier including parallel resonant inductors of the disclosure may be disposed in the RFIC, and the parallel resonant inductors may be disposed in at least one of a front end or a rear end of elements for an amplification function of the low noise amplifier.

Due to the structure of the low noise amplifier including parallel resonant inductors according to an embodiment of the disclosure, a switching element (e.g., capacitor) for switching between a power amplifier and the low noise amplifier may not need to be additionally disposed in the RF processor 713, and loss may also be minimized. In addition, since a switching element for the low noise amplifier is not disposed additionally, an area occupied by the RF processor 713 in an electronic device may be reduced. Accordingly, the electronic device may include a larger number of RF components or the electronic device may be downsized. In addition, due to the structure of the low noise amplifier including parallel resonant inductors according to an embodiment of the disclosure, the area occupied by the RF processor 713 is reduced and interference from neighboring RF components may be minimized. Accordingly, an additional process is not required and it may be advantageous for mass production of electronic devices.

The controller 714 may control the overall operations of the electronic device 710. The controller 714 may include various modules for performing communication. The controller 714 may include at least one processor such as a modem. The controller 714 may include modules for digital signal processing. For example, the controller 714 may include a modem. In the case of data transmission, the controller 714 may generate complex symbols by encoding and modulating a transmission bitstream. In addition, in the case of data reception, the controller 714 may restore a reception bitstream by demodulating and decoding a baseband signal. The controller 714 may perform the functions of a protocol stack that the communication standard requires.

The functional configuration of the electronic device 710, as equipment to which a device according to various embodiments of the disclosure is applicable, has been described in FIG. 7. However, the example illustrated in FIG. 7 is merely an exemplary configuration of a device for a structure according to various embodiments of the disclosure described via FIG. 1 to FIG. 6B, and the embodiments of the disclosure are not limited to the components of the equipment illustrated in FIG. 7. Therefore, the low noise amplifier structure including parallel resonant inductors and the electronic device including the structure may also be construed as an embodiment of the disclosure.

In addition, the disclose is not limited to the structures shown in FIG. 1 to 6B. For example, it is illustrated that parallel resonant inductors are disposed in a front end in a low noise amplifier in FIG. 1 to FIG. 6B of the disclosure. However, as described above, another structure may be allowed in consideration of other elements that perform an amplification function. As another example, although it is illustrated that a switch of a power amplifier connected in series and a low noise amplifier including parallel resonant inductors are disposed in an RFIC front end of the disclosure, an antenna switch for switching the power amplifier and the low noise amplifier may be further disposed, instead of the switch of the power amplifier. In other words, by adjusting the disposition in consideration of the structure or the number of parallel resonant inductors, or the relationship with another element, the RFIC front end structure may be changed for efficient impedance matching.

Although, for ease of description, two inductors and a capacitor are illustrated in FIGS. 1 to 6B as a parallel resonant inductor structure included in a low noise amplifier, a structure according to the present disclosure is not limited thereto. For example, the parallel resonant inductor structure according to an embodiment of the disclosure may further include a plurality of resonant elements, in addition to a plurality of inductors and a capacitor.

According to various embodiments of the disclosure, a low noise amplifier may include a first inductor, a second inductor, and a capacitor, and the first inductor and the second inductor may be disposed in parallel, the first inductor and the second inductor may be in a resonant state (resonance), and the capacitor may be disposed between the first inductor and the second inductor, with a space therebetween.

According to an embodiment, the first inductor and the second inductor may be provided in a spiral structure, and the first inductor, the second inductor, and the capacitor may be layered horizontally.

According to an embodiment, an induced voltage polarity of the first inductor and an induced voltage polarity of the second inductor may be opposite.

According to an embodiment, the low noise amplifier may include at least one of a cascode amplifier structure or a differential amplifier structure.

According to an embodiment, the low noise amplifier may be configured as a distributed active transformer based on at least one transformer.

According to an embodiment, the low noise amplifier may include at least one transistor for low noise amplification.

According to an embodiment, the at least one transistor may include a first capacitor connected between a gate and a drain, a second capacitor connected between a gate and a source, impedance connected between the drain and the source, and a dependent voltage source connected between the gate and the source.

According to an embodiment, a value of the capacitor and a value of the first capacitor may be 0, and a value of a coupling factor between the first inductor and the second inductor may be 1.

According to an embodiment, a value of the impedance connected between the drain and the source in the case of signal transmission may be the same as a value of the impedance connected between the drain and the source in the case of signal reception.

According to an embodiment, inductance of the first inductor and inductance of the second inductor may be the same value.

According to various embodiments of the disclosure, an electronic device of a wireless communication system may include a plurality of radio frequency integrated circuits (RFICs), and at least one RFIC of the plurality of RFICs may include a low noise amplifier, the low noise amplifier may include a first inductor, a second inductor, and a capacitor, the first inductor and the second inductor may be disposed in parallel, the first inductor and the second inductor may be in a resonant state (resonance), and the capacitor may be disposed between the first inductor and the second inductor, with a space therebetween.

According to an embodiment, the first inductor and the second inductor may be provided in a spiral structure, and the first inductor, the second inductor, and the capacitor may be layered horizontally.

According to an embodiment, an induced voltage polarity of the first inductor and an induced voltage polarity of the second inductor may be opposite.

According to an embodiment, the low noise amplifier may include at least one of a cascode amplifier structure or a differential amplifier structure.

According to an embodiment, the low noise amplifier may be configured as a distributed active transformer based on at least one transformer.

According to an embodiment, the low noise amplifier may include at least one transistor for low noise amplification.

According to an embodiment, the at least one transistor may include a first capacitor connected between a gate and a drain, a second capacitor connected between a gate and a source, impedance connected between the drain and the source, and a dependent voltage source connected between the gate and the source.

According to an embodiment, a value of the capacitor and a value of the first capacitor may be 0, and a value of a coupling factor between the first inductor and the second inductor may be 1.

According to an embodiment, a value of the impedance connected between the drain and the source in the case of signal transmission may be the same as a value of the impedance connected between the drain and the source in the case of signal reception.

According to an embodiment, inductance of the first inductor and inductance of the second inductor may be the same value.

It should be noted that the above-described configuration diagrams, illustrative diagrams of control/data signal transmission methods, illustrative diagrams of operation procedures, and structural diagrams are not intended to limit the scope of the disclosure. That is, all constituent units, elements, or entities described in the embodiments of the disclosure should not be construed as being essential for the implementation of the disclosure, and the disclosure may be implemented without impairing the essential features of the disclosure by including only some constituent elements. Also, the above respective embodiments may be employed in combination, as necessary. For example, parts of the structures proposed in the disclosure may be deployed or configured in combination.

In the above-described detailed embodiments of the disclosure, an element included in the disclosure is expressed in the singular or the plural according to presented detailed embodiments. However, the singular form or plural form is selected appropriately to the presented situation for the convenience of description, and the disclosure is not limited by elements expressed in the singular or the plural. Therefore, either an element expressed in the plural may also include a single element or an element expressed in the singular may also include multiple elements.

Although specific embodiments have been described in the detailed description of the disclosure, it will be apparent that various modifications and changes may be made thereto without departing from the scope of the disclosure. Therefore, the scope of the disclosure should not be defined as being limited to the embodiments set forth herein, but should be defined by the appended claims and equivalents thereof. That is, it will be apparent to those skilled in the art that other variants based on the technical idea of the disclosure may be implemented. Also, the above respective embodiments may be employed in combination, as necessary. As an example, the methods proposed in the disclosure may be partially combined with each other to operate a base station and a terminal. Moreover, although the above embodiments have been described based on 5G and NR systems, other variants based on the technical idea of the embodiments may also be implemented in other communication systems such as LTE, LTE-A, and LTE-A-Pro systems.

Although specific embodiments have been described in the detailed description of the disclosure, it will be apparent that various modifications and changes may be made thereto without departing from the scope of the disclosure. Therefore, the scope of the disclosure should not be defined as being limited to the embodiments set forth herein, but should be defined by the appended claims and equivalents thereof.

## Claims

1. A low noise amplifier comprising:

    a first inductor;
    a second inductor; and
    a capacitor,
    wherein the first inductor and the second inductor are disposed in parallel,
    wherein the first inductor and the second inductor are in a resonant state, and
    wherein the capacitor is disposed between the first inductor and the second inductor with a space therefrom.

2. The low noise amplifier of claim 1,

    wherein the first inductor and the second inductor are provided in a spiral structure, and
    wherein the first inductor, the second inductor, and the capacitor are layered horizontally.

3. The low noise amplifier of claim 1, wherein an induced voltage polarity of the first inductor is opposite to an induced voltage polarity of the second inductor.

4. The low noise amplifier of claim 1, wherein the low noise amplifier comprises at least one of a cascode amplifier structure or a differential amplifier structure.

5. The low noise amplifier of claim 1, wherein the low noise amplifier is configured as a distributed active transformer based on at least one transformer.

6. The low noise amplifier of claim 1, wherein the low noise amplifier comprises at least one transistor for low noise amplification.

7. The low noise amplifier of claim 6, wherein the at least one transistor comprises a first capacitor connected between a gate and a drain, a second capacitor connected between the gate and a source, impedance connected between the drain and the source, and a dependent voltage source connected between the gate and the source.

8. The low noise amplifier of claim 7,

wherein a value of the capacitor and a value of the first capacitor are 0, and

wherein a value of a coupling factor between the first inductor and the second inductor is 1.

9.  The low noise amplifier of claim 7, wherein a value of the impedance connected between the drain and the source in case of signal transmission is identical to a value of the impedance connected between the drain and the source in case of signal reception.

10. The low noise amplifier of claim 7, wherein inductance of the first inductor and inductance of the second inductor have an identical value.

11. An electronic device of a wireless communication system, the electronic device comprising a plurality of radio frequency integrated circuits (RFICs),

wherein at least one of the plurality of RFICs comprises a low noise amplifier, wherein the low noise amplifier comprises a first inductor, a second inductor, and a capacitor,

wherein the first inductor and the second inductor are disposed in parallel,

wherein the first inductor and the second inductor are in a resonant state, and

wherein the capacitor is disposed between the first inductor and the second inductor with a space therefrom.

12. The electronic device of claim 11,

wherein the first inductor and the second inductor are provided in a spiral structure, and

wherein the first inductor, the second inductor, and the capacitor are layered horizontally.

13. The electronic device of claim 11, wherein an induced voltage polarity of the first inductor is opposite to an induced voltage polarity of the second inductor.

14. The electronic device of claim 11, wherein the low noise amplifier comprises at least one of a cascode amplifier structure or a differential amplifier structure.

15. The electronic device of claim 11, wherein the low noise amplifier is configured as a distributed active transformer based on at least one transformer.

FIG.1

**FIG.2**

300

315          316          317

ANT

BIAS off/on          VDD          Next stage

$Z_{IN}$

320          313

311          $C_1$          $M_1$ — 314

$L_P$          $k_f$          $L_S$ — 310

$M_2$          — 312

Mutually coupled parallel resonance

TXSW on/off

PA

FIG.3

First metal (410)
Second metal (420)
Third metal (430)
Fourth metal (440)
} Metal layer

FIG.4A

FIG.4B

500

Rx mode equivalent circuit

505

508

507

509

501 $Z_{IN\_RX}$

Gate

Drain

$C_{M2\_OFF}$

$C_{gd}$

511

$+$

$V_{gs}$

$C_{gs}$

$V_{gs}$

$Z_{ds}$ ON

$Z_L$

$Z_0$

$g_m$

510

$Z_{PA\_OFF}$

$L_P$

$-$

$k_f$

506

504

502

Source

$L_S$

503

M1 equivalent model

FIG.5A

550

Tx mode equivalent circuit

555

558

551

Gate

557

Drain

$C_{gd}$

$Z_0$

$Z_{OUT\_TX}$

$L_P$ 0

$C_{gs}$

$Z_{ds}$ OFF $Z_L$

$k_f$

552

556

554

Source

$L_S$ 0

553

M1 equivalent model

FIG.5B

FIG.6A

621

Tx path ANT.

Off state
of LNA

50
50

623

Expected insertion loss
@ Tx mode

Frequency, GHz

FIG.6B

EP 4 622 098 A1

FIG.7

## INTERNATIONAL SEARCH REPORT

| International application No. |
|---|
| **PCT/KR2023/015074** |

| A. | CLASSIFICATION OF SUBJECT MATTER |
|---|---|

**H03F 1/26**(2006.01)i; **H03F 1/56**(2006.01)i; **H03F 3/193**(2006.01)i; **H03F 1/22**(2006.01)i

According to International Patent Classification (IPC) or to both national classification and IPC

| B. | FIELDS SEARCHED |
|---|---|

Minimum documentation searched (classification system followed by classification symbols)

H03F 1/26(2006.01); H01P 5/10(2006.01); H03F 1/08(2006.01); H03F 1/22(2006.01); H03F 1/42(2006.01); H03F 1/44(2006.01); H03F 1/56(2006.01); H03F 3/195(2006.01); H03H 7/01(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 인덕터(inductor), 커패시터(capacitor), 증폭기(amplifier), 저잡음(low noise), 전압 (voltage), 유도(induce), 병렬(parallel)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-1091431 B1 (SONY CORPORATION) 07 December 2011 (2011-12-07) See paragraphs [0019]-[0090] and figures 1-7. | 1,4,6-7,9-11,14 |
| Y | | 2-3,5,8,12-13,15 |
| Y | KR 10-2009-0022527 A (KWANGWOON UNIVERSITY INDUSTRY-ACADEMIC COLLABORATION FOUNDATION et al.) 04 March 2009 (2009-03-04) See abstract, paragraphs [0017]-[0018], claims 1-5 and figures 1-5. | 2-3,5,8,12-13,15 |
| A | KR 10-1037613 B1 (SAMSUNG ELECTRO-MECHANICS CO., LTD. et al.) 31 May 2011 (2011-05-31) See claim 1. | 1-15 |
| A | KR 10-2018-0094562 A (HANBAT NATIONAL UNIVERSITY INDUSTRY-ACADEMIC COOPERATION FOUNDATION) 24 August 2018 (2018-08-24) See claims 1-5. | 1-15 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 January 2024** | **12 January 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/015074** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2020-0220508 A1 (PSEMI CORPORATION) 09 July 2020 (2020-07-09)<br>See entire document. | 1-15 |

Form PCT/ISA/210 (second sheet) (July 2022)

## INTERNATIONAL SEARCH REPORT
### Information on patent family members

International application No.

**PCT/KR2023/015074**

| Patent document cited in search report | | | Publication date (day/month/year) | Patent family member(s) | | | Publication date (day/month/year) |
|---|---|---|---|---|---|---|---|
| KR | 10-1091431 | B1 | 07 December 2011 | CN | 1886892 | B | 13 October 2010 |
| | | | | CN | 1886892 | C | 27 December 2006 |
| | | | | EP | 1693956 | A1 | 23 August 2006 |
| | | | | EP | 1693956 | A4 | 29 October 2008 |
| | | | | EP | 1693956 | B1 | 23 January 2013 |
| | | | | JP | 2005-175819 | A | 30 June 2005 |
| | | | | KR | 10-2006-0121156 | A | 28 November 2006 |
| | | | | SG | 144781 | A1 | 28 August 2008 |
| | | | | US | 2007-0139117 | A1 | 21 June 2007 |
| | | | | US | 8019306 | B2 | 13 September 2011 |
| | | | | WO | 2005-057780 | A1 | 23 June 2005 |
| KR | 10-2009-0022527 | A | 04 March 2009 | None | | | |
| KR | 10-1037613 | B1 | 31 May 2011 | KR | 10-2010-0078760 | A | 08 July 2010 |
| KR | 10-2018-0094562 | A | 24 August 2018 | WO | 2018-151437 | A1 | 23 August 2018 |
| US | 2020-0220508 | A1 | 09 July 2020 | CN | 113366759 | A | 07 September 2021 |
| | | | | US | 10700650 | B1 | 30 June 2020 |
| | | | | US | 10951252 | B2 | 16 March 2021 |
| | | | | US | 11728837 | B2 | 15 August 2023 |
| | | | | US | 2020-0220567 | A1 | 09 July 2020 |
| | | | | US | 2021-0409055 | A1 | 30 December 2021 |
| | | | | WO | 2020-146504 | A1 | 16 July 2020 |

Form PCT/ISA/210 (patent family annex) (July 2022)